# EUROPEAN PATENT APPLICATION

(11) **EP 1 630 608 A2**
(43) Date of publication of application: **01.03.2006**
(21) Application number: 05107561.2
(22) Date of filing: 17.08.2005
(51) Int. Cl.: G03F 7/09

(54) **Planographic printing plate precursor**

(30) Priority: 26.08.2004 JP 2004246413
(71) Applicant: Konica Minolta Medical & Graphic, Inc., Tokyo 163-0512 (JP)
(72) Inventor: Kuroki, Takaaki Konica Medical & Graphic,Inc., 192-8505, Tokyo (JP); Matsumura,Toshiyuki, Ishikawa-machi,Hachioji,Tokyo,192-8505 (JP)
(74) Representative: Henkel, Feiler & Hänzel

(57) **Abstract**

Disclosed is a planographic printing plate material comprising a support and provided thereon, a photopolymerizable light sensitive layer and a protective layer in the order, wherein the protective layer contains a polyvinyl alcohol derivative A having a saponification degree of 90 to 100 mol% and a solubility of 0.1 to 10 g per liter of 50 °C water, and wherein a viscosity at 20 °C of an aqueous solution containing 4% by weight of the polyvinyl alcohol derivative, measured according to JIS K6726, is from 4.5 to 200 mPa·s.

## Description

This application is based on Japanese Patent Application No. 2004-246413 filed on August 26, 2004 in Japanese Patent Office, the entire content of which is hereby incorporated by reference.

### FIELD OF THE INVENTION

The present invention relates to a photopolymerizable light sensitive planographic printing plate material used in computer to plate system (hereinafter also referred to as CTP).

### BACKGROUND OF THE INVENTION

In recent years, in a plate-making process of a printing plate for off-set printing, CTP, which records digital image data directly on a light sensitive printing plate material employing laser light, has been developed and practically used.

It is known that of printing plate materials used for CTP, a negative working light sensitive planographic printing plate material comprising a polymerizable light sensitive layer containing a polymerizable compound is used in a printing field in which relatively high printing durability is required (see for example, Japanese Patent O.P.I. Publication No. 10-104835).

The planographic printing plate material comprising a polymerizable light sensitive layer has problem in that the light sensitive layer reduces sensitivity due to oxygen, resulting in lowering of storage stability. As a method to minimize the influence of oxygen, it is well known that an oxygen-shielding layer (protective layer) is provided on the light sensitive layer.

As a method providing an oxygen-shielding layer, there are a method providing a protective layer containing polyvinyl alcohol and a vinyl pyrrolidone copolymer containing 50 mol% or more of a vinyl pyrrolidone unit and having a weight average molecular weight of from 10,000 to 400,000 (see Japanese Patent O.P.I. Publication No. 8-286379), a method providing an oxygen-shielding layer containing polyvinyl acetate having an average saponification degree of from 70% to less than 85% and polyvinyl acetate having an average saponification degree of from 85% to less than 100% (see Japanese Patent O.P.I. Publication No. 9-204049), a method providing a protective layer containing a water-soluble vinyl polymer and a water-soluble polymer which is immiscible with polyvinyl alcohol (see Japanese Patent O.P.I. Publication No. 11-119438), and a method providing a protective layer containing polyvinyl alcohol and a specific polymer containing a vinyl acetate unit as a co-monomer unit (see Japanese Patent O.P.I. Publication No. 11-311862).

However, these methods have problems in that sensitivity is insufficient or storage stability is insufficient, for example, sensitivity varies after storage or stain occurs after storage. Further, when preheating is carried out before development in order to enhance printing durability, these methods have also problems in that admissible heating temperature range is narrow, development latitude is also narrow, and adhesion of the protective layer to the light sensitive layer is poor. It has been difficult to satisfy all of sensitivity, coatability, productivity, developability and storage stability of planographic printing plate material, employing the above methods.

### SUMMARY OF THE INVENTION

An object of the invention is to provide a planographic printing plate material comprising a photopolymerizable light sensitive layer and a protective layer, the planographic printing plate material having high sensitivity, storage stability and developing latitude, and a protective layer exhibiting good coatability and good adhesion.

### DETAILED DESCRIPTION OF THE INVENTION

The above object of the present invention can be attained by the following constitution.
1. A planographic printing plate material comprising a support and provided thereon, a photopolymerizable light sensitive layer and a protective layer in the order, wherein the protective layer contains a polyvinyl alcohol derivative A having a saponification degree of 90 to 100 mol% and a solubility of 0.1 to 10 g per liter of 50 °C water; and wherein a viscosity at 20 °C of an aqueous solution containing 4% by weight of the polyvinyl alcohol derivative, measured according to JIS K6726, is from 4.5 to 200 mPa·s.
2. The planographic printing plate material of item 1 above, wherein the content of the polyvinyl alcohol derivative A in the protective layer is from 40 to 100% by weight.
3. The planographic printing plate material of item 2 above, wherein the content of the polyvinyl alcohol derivative A in the protective layer is from 40 to 94% by weight.
4. The planographic printing plate material of item 1 above, wherein the protective layer further contains a polyvinyl alcohol B having a saponification degree of 85 to 90 mol%.
5. The planographic printing plate material of item 4 above, wherein the content of the polyvinyl alcohol B in the protective layer is from 5 to 50% by weight.
6. The planographic printing plate material of item 4 above, wherein the content of the polyvinyl alcohol B in the protective layer is from 5 to 30% by weight based on the polyvinyl alcohol derivative.
7. The planographic printing plate material of item 1 above, wherein the protective layer further contains 1 to 30% by weight of a vinyl pyrrolidone polymer C (a vinyl pyrrolidone homopolymer or a vinyl pyrrolidone copolymer) having a weight average molecular weight of from 10,000 to 500,000 and having a vinyl pyrrolidone unit of not less than 40 mol%.
8. The planographic printing plate material of item 1 above, wherein the protective layer is formed by coating a protective layer coating liquid on the photopolymerizable light sensitive layer, and drying, the protective layer coating liquid containing a polyvinyl alcohol derivative A having (a) a saponification degree of 90 to 100%, (b) a viscosity of from 4.5 to 200 mPa·s, and (c) a solubility of 0.1 to 10 g per liter of to 50 °C water, the viscosity being a viscosity at 20 °C of an aqueous solution containing 4% of the polyvinyl alcohol derivative, measured according to JIS K6726.

The present invention provides a planographic printing plate material with high sensitivity, reduced variation of sensitivity or anti-stain property after storage stability, and excellent preheating latitude, which exhibits good coatability of the protective layer, providing minimized image defects, and good adhesion of the protective layer.

Next, the present invention will be explained in detail.

The present invention is a planographic printing plate material comprising a support and provided thereon, a photopolymerizable light sensitive layer and a protective layer in the order, wherein the protective layer contains a polyvinyl alcohol derivative A having a saponification degree of 90 to 100 mol% and a solubility of 0.1 to 10 g per liter of 50 °C water, and wherein a viscosity at 20 °C of an aqueous solution containing 4% by weight of the polyvinyl alcohol derivative, measured according to JIS K6726, is from 4.5 to 200 mPa·s.

### «Protective layer, protective layer coating liquid»

The protective layer in the invention is provided in order to prevent the photopolymerizable light sensitive layer from undergoing polymerization inhibition due to oxygen. The protective layer is formed by coating a protective layer coating liquid containing a polyvinyl alcohol derivative as described below on the photopolymerizable light sensitive layer and drying.

### (Polyvinyl alcohol derivative A)

The protective layer in the invention contains a polyvinyl alcohol derivative A having a saponification degree of 90 to 100 mol% and a solubility of 0.1 to 10 g per liter of 50 °C water, and wherein a viscosity at 20 °C of an aqueous solution containing 4% by weight of the polyvinyl alcohol derivative, measured according to JIS K6726, is from 4.5 to 200 mPa·s.

In the invention, the saponification degree refers to a mol percentage of vinyl alcohol unit based on the sum of vinyl alcohol unit, vinyl acetate unit and modified vinyl alcohol unit in the polyvinyl alcohol derivative A or polyvinyl alcohol.

In the invention, the polyvinyl alcohol derivative has a saponification degree of preferably 95 to 100%.

The protective layer contains polyvinyl alcohol derivative A in an amount of preferably not less than 40% by weight, more preferably from 40 to 94% by weight, and still more preferably from 60 to 94% by weight.

The polyvinyl alcohol derivative A in the invention is required to have a viscosity of from 4.5 to 200 mPa.s, the viscosity being a viscosity at 20 °C of an aqueous solution containing 4% of the polyvinyl alcohol derivative, measured according to testing methods for polyvinyl alcohol as described in JIS K6726 (corresponding to ICS 83. 080.20).

The polyvinyl alcohol derivative A in the invention has a weight average molecular weight of preferably from 15,000 to 150,000, and more preferably from 20,000 to 200,000.

In the invention, a solubility to 50 °C water of sample is determined as follows: Fifty grams of sample (obtained by passing through a 14 mesh filter) are added to 1 liter of 50 °C water, stirred with a stirrer with a 5 cm stirrer piece at 250 rpm for 30 minutes, filtered with a 300 mesh metal filter to obtain a residue on the filter. The solubility is a value (g/liter) obtained by subtracting the amount of the residue from the amount of the sample to have been added. As the 14 mesh filter, a plain weave wire gauze of stainless steel (SUS 304) (with a wire diameter of 0.5 mm), produced by Matsubara Kanaami Co., Ltd.), was used.

The polyvinyl alcohol derivative A in the invention is obtained by saponifying a modified polyvinyl acetate derivative or by modifying polyvinyl alcohol prepared by saponifying polyvinyl acetate with an alkali or an acid.

As modifying methods, there are a method which reacts PVA with an ester of a carboxylic acid with a polyhydric alcohol while heating, a method which reacts polyvinyl alcohol (including its derivative) with a carboxylic acid in the presence of at least a carboxyl activating agent selected from carbonyldiimidazole, carbonylditriazole, cabonyldiimides and their hydrochloric acid salts to obtain an ester, and a method which incorporates polyoxyalkylene, acetal or ketal in polyvinyl alcohol (including its derivative).

### (Polyvinyl alcohol B having a saponification degree of 85 to 90 mol%)

It is preferred that polyvinyl alcohol B having a saponification degree of 85 to 90 mol% is used together with the polyvinyl alcohol derivative A above.

The content of the polyvinyl alcohol B in the protective layer is preferably from 5 to 50% by weight, and more preferably from 10 to 40% by weight, from the viewpoint of sensitivity, coatability, or storage stability. The content of the polyvinyl alcohol B in the protective layer is preferably from 5 to 30% by weight based on the content of polyvinyl alcohol derivative A, from the viewpoint of sensitivity, coatability, or storage stability.

The polyvinyl alcohol B having a saponification degree of 85 to 90 mol% has a viscosity at 20 °C of preferably from 1 to 100 mPa·s, and more preferably from 2 to 60 mPa.s, the viscosity being measured according to the polyvinyl alcohol test in JIS K6726. (Vinyl pyrrolidone copolymer C with a weight average molecular weight of from 10,000 to 500,000 having a vinyl pyrrolidone unit of not less than 40 mol%) It is preferred that vinyl pyrrolidone copolymer C with a weight average molecular weight of from 10,000 to 500,000 having a vinyl pyrrolidone unit of not less than 40 mol% is used together with the polyvinyl alcohol derivative A above.

The content of the vinyl pyrrolidone copolymer C in the protective layer is preferably from 1 to 30% by weight, and more preferably from 2 to 40% by weight, from the viewpoint of sensitivity, coatability, or storage stability. The content of the vinyl pyrrolidone polymer C (vinyl pyrrolidone homopolymer or copolymer) in the protective layer is preferably from 3 to 70% by weight, and more preferably from 10 to 50% by weight, based on the content of polyvinyl alcohol derivative A.

The weight average molecular weight of the vinyl pyrrolidone copolymer is from 10,000 to 500,000, and preferably from 30,000 to 250,000.

The vinyl pyrrolidone polymer can be synthesized by copolymerizing N-vinyl-2-pyrrolidone with a co-monomer according to a conventional radical polymerization. The co-monomer may be any monomer, and is preferably vinyl acetate.

The vinyl pyrrolidone copolymers can be used as an admixture of one or more kinds thereof.

### (Other materials)

The protective layer in the invention can further contain a water-soluble compound, a surfactant, or a matting agent.

Examples of the water-soluble compound include polyvinyl alcohol, polysaccharide, polyvinyl pyrrolidone, polyethylene glycol, gelatin, glue, casein, hydroxyethyl cellulose, carboxymethylcellulose, methylcellulose, hydroxyethyl starch, gum arabic, sucrose octacetate, ammonium alginate, sodium alginate, polyvinyl amine, polyethylene oxide, polystyrene sulfonic acid, polyacrylic acid, or a water soluble polyamide.

The surfactant may be any of an anionic, nonionic, cationic and amphoteric surfactant, and is preferably a fluorine-containing surfactant.

As the matting agent, inorganic or organic particles with a particle diameter of approximately from 0.1 to 10 µm can be used.

The protective layer coating liquid is obtained by dissolving the materials described above in a solvent. The coating liquid is coated on the photopolymerizable light sensitive layer and dried to form the protective layer. The dry thickness of the protective layer is preferably from 0.1 to 5.0 µm, and more preferably from 0.5 to 3.0 µm.

### (Protective layer coating liquid)

The protective layer coating liquid can be obtained by dissolving the materials described above in a solvent containing mainly water. Examples of the solvent other than water include alcohols or polyhydric alcohols.

The solvent containing mainly water means a solvent containing water in an amount of not less than 50% by weight. The solvent containing mainly water in the invention contains water in an amount of preferably not less than 75% by weight, and more preferably not less than 95% by weight.

The protective layer coating liquid is coated on the photopolymerizable light sensitive layer and dried to form the protective layer.

The drying temperature of the protective layer formed after coating of the protective layer coating liquid is preferably lower than a glass transition temperature (Tg) of the binder contained in the photopolymerizable light sensitive layer. The drying temperature of the protective layer is preferably not less than 20 °C lower than Tg of the binder contained in the light sensitive layer, and more preferably not less than 40 °C lower than Tg of the binder contained in the light sensitive layer. The drying temperature of the protective layer is preferably at most 60 °C lower than Tg of the binder contained in the light sensitive layer.

The protective layer coating liquid may contain a surfactant.

As the coating method of the protective layer coating liquid, there are known coating methods such as an air doctor coating method, a blade coating method, a wire bar coating method, a knife coating method, a dip coating method, a reverse roll coating method, a gravure coating method, a cast coating method, a curtain coating method, and an extrusion coating method.

### (Photopolymerizable light sensitive layer)

The photopolymerizable light sensitive layer is a layer which is capable of being hardened upon imagewise light exposure to form an image. The photopolymerizable light sensitive layer contains (1) a polymerizable ethylenically unsaturated monomer, (2) a photopolymerization initiator, and (3) a polymer binder.

### (1) Polymerizable ethylenically unsaturated monomer

The polymerizable ethylenically unsaturated monomer is a compound having in the molecule a polymerizable ethylenically unsaturated bond. As the polymerizable ethylenically unsaturated monomer, there are conventional radical polymerizable monomers, polyfunctional monomers having plural ethylenically unsaturated bond, and polyfunctional oligomers.

The polymerizable ethylenically unsaturated monomer is not specifically limited. Examples thereof include a monofunctional acrylate such as 2-ethylhexyl acrylate, 2-hydroxypropyl acrylate, glycerol acrylate, tetrahydrofurfuryl acrylate, phenoxyethyl acrylate, nonylphenoxyethyl acrylate, tetrahydrofurfuryl-oxyethyl acrylate, tetrahydrofurfuryloxyhexanorideacrylate; a methacrylate, itaconate, crotonate or maleate alternative of the above acrylate; a bifunctional acrylate such as ethyleneglycol diacrylate, triethyleneglycol diacrylate, pentaerythritol diacrylate, hydroquinone diacrylate, resorcin diacrylate, hexanediol diacrylate, neopentyl glycol diacrylate, tripropylene glycol diacrylate, hydroxypivalic acid neopentyl glycol diacrylate, neopentyl glycol adipate diacrylate, diacrylate of hydroxypivalic acid neopentyl glycol-ε-caprolactone adduct, 2-(2-hydroxy-1,1-dimethylethyl)-5-hydroxymethyl-5-ethyl-1,3-dioxane diacrylate, tricyclodecanedimethylol acrylate, tricyclodecanedimethylol acrylate-ε-caprolactone adduct or 1,6-hexanediol diglycidylether diacrylate; a dimethacrylate, diitaconate, dicrotonate or dimaleate alternative of the above diacrylate; a polyfunctional acrylate such as trimethylolpropane triacrylate, ditrimethylolpropane tetraacrylate, trimethylolethane triacrylate, pentaerythritol triacrylate, pentaerythritol tetraacrylate, dipentaerythritol tetraacrylate, dipentaerythritol pentaacrylate, dipentaerythritol hexacrylate, dipentaerythritol hexacrylate-ε-caprolactone adduct, pyrrogallol triacrylate, propionic acid dipentaerythritol triacrylate, propionic acid dipentaerythritol tetraacrylate or hydroxypivalylaldehyde modified dimethylolpropane triacrylate or EO-modified products thereof; and a methacrylate, itaconate, crotonate or maleate alternative of the above polyfunctional acrylate.

### (Polymerizable ethylenically unsaturated monomer containing a light oxidizable group)

The polymerizable ethylenically unsaturated monomer in the invention is preferably a polymerizable ethylenically unsaturated monomer containing a light oxidizable group.

A polymerizable ethylenically unsaturated monomer containing both light oxidizable group and a urethane group is especially preferred. Examples of the light oxidizable group include a thio group, thioether group, a ureido group, an amino group, and an enol group, each of which may be a member constituting heterocycles. As moieties containing these groups, there are, for example, a triethanolamine moiety, a triphenylamine moiety, a thioureide moiety an imidazole moiety, an oxazole moiety, a thiazole moiety, an acetylacetone moiety, an N-phenylglycine moiety, and an ascorbic acid moiety. Preferred is a polymerizable monomer containing a tertiary amino group or a thioether group.

Exemplified compounds containing a light oxidizable group are listed in European Patent Publication Nos. 287,818, 353,389 and 364,735. Among the exemplified compounds, compounds containing a tertiary amino group, and a ureido group and/or a urethane group are preferred.

Examples of the addition polymerizable ethylenically unsaturated monomer containing both light oxidizable group and a urethane group are listed in Japanese Patent Publication No. 2669849, and Japanese Patent O.P.I. Publication Nos. 63-260909, 6-35189, and 2001-125255.

In the invention, a reaction product of a tertiary amine having two or more hydroxyl groups in the molecule, a diisocyanate and a compound having a hydroxyl group and an addition polymerizable ethylenically double bond in the molecule is preferably used.

The tertiary amine having two or more hydroxyl groups in the molecule has a hydroxyl group of preferably from 2 to 6, and more preferably from 2 to 4. Examples of the tertiary amine having two or more hydroxyl groups in the molecule include triethanolamine, N-methyldiethanolamine, N-ethyldiethanolamine, N-ethyldiethanolamine, N-n-butyldiethanolamine, N-tert-butyldiethanolamine, N,N-di(hydroxyethyl)aniline, N,N, N', N'-tetra-2-hydroxypropylethylenediamine, p-tolyldiethanolamine, N,N, N', N'-tetra-2-hydroxyethylethylenediamine, N,N-bis(2-hydroxypropyl)aniline, allyldiethanolamine, 3-dimethylamino-1,2-propane diol, 3-diethylamino-1,2-propane diol, N,N-di(n-propylamino)-2,3-propane diol, N,N-di(iso-propylamino)-2,3-propane diol, and 3-(N-methyl-N-benzylamino)-1,2-propane diol, but the invention is not specifically limited thereto.

Examples of the diisocyanate include butane-1,4-diisocyanate, hexane-1,6-diisocyanate, 2-methylpentane-1,5-diisocyanate, octane-1,8-diisocyanate, 1,3-diisocyanatomethylcyclohexanone, 2,2,4-trimethylhexane-1,6-diisocyanate, isophorone diisocyanate, 1,2-phenylene diisocyanate, 1,3-phenylene diisocyanate, 1,4-phenylene diisocyanate, tolylene-2,4-diisocyanate, tolylene-2,5-diisocyanate, tolylene-2,6-diisocyanate, 1,3-di(isocyanatomethyl)benzene, and 1,3-bis(1-isocyanato-1-methylethyl)benzene, but the invention is not specifically limited thereto. Examples of the compound having a hydroxyl group and an addition polymerizable ethylenically double bond in the molecule is not specifically limited, but 2-hydroxyethyl methacrylate, 2-hydroxyethyl acrylate, 4-hydroxybutyl acrylate, 2-hydroxypropylene-1,3-dimethacrylate, and 2-hydroxypropylene-1-methacrylate-3-acrylate are preferred.

The reaction product can be synthesized according to the same method as a conventional method in which a urethaneacrylate compound is ordinarily synthesized employing a diol, a diisocyanate and an acrylate having a hydroxyl group.

Examples of the reaction product of a tertiary amine having two or more hydroxyl groups in the molecule, a diisocyanate having an aromatic ring in the molecule and a compound having a hydroxyl group and an addition polymerizable ethylenically double bond in the molecule will be listed below.
M-1: A reaction product of triethanolamine (1 mole), hexane-1,6-diisocyanate (3 moles), and 2-hydroxyethyl methacrylate (3 moles)
M-2: A reaction product of triethanolamine (1 mole), isophorone diisocyanate (3 moles), and 2-hydroxyethyl methacrylate (3 moles)
M-3: A reaction product of N-n-butyldiethanolamine (1 mole), 1,3-bis(1-cyanato-1-methylethyl)benzene (2 moles), and 2-hydroxypropylene-1-methacrylate-3-acrylate (2 moles)
M-4: A reaction product of N-n-butyldiethanolamine (1 mole), 1,3-di(cyanatomethyl)benzene (2 moles), and 2-hydroxypropylene-1-methacrylate-3-acrylate (2 moles)
M-5: A reaction product of N-methydiethanolamine (1 mole), tolylene-2,4-diisocyanate (2 moles), and 2-hydroxypropylene-1,3-dimethacrylate (2 moles)

In addition to the above, acrylates or methacrylates disclosed in Japanese Patent O.P.I. Publication Nos. 2-105238 and 1-127404 can be used.

### (Other polymerizable ethylenically unsaturated compound)

A prepolymer can be used, and examples of the prepolymer include compounds as described later. The prepolymer with a photopolymerizable property, which is obtained by incorporating acrylic acid or methacrylic in an oligomer with an appropriate molecular weight, can be suitably employed. This prepolymer can be used singly, as an admixture of the above described monomers and/or oligomers.

Examples of the prepolymer include polyester (meth)acrylate obtained by incorporating (meth)acrylic acid in a polyester of a polybasic acid such as adipic acid, trimellitic acid, maleic acid, phthalic acid, terephthalic acid, hymic acid, malonic acid, succinic acid, glutaric acid, itaconic acid, pyromellitic acid, fumalic acid, pimelic acid, sebatic acid, dodecanic acid or tetrahydrophthalic acid with a polyol such as ethylene glycol, ethylene glycol, diethylene glycol, propylene oxide, 1,4-butane diol, triethylene glycol, tetraethylene glycol, polyethylene glycol, grycerin, trimethylol propane, pentaerythritol, sorbitol, 1,6-hexanediol or 1,2,6-hexanetriol; an epoxyacrylate such as bisphenol A·epichlorhydrin·(meth)acrylic acid or phenol novolak·epichlorhydrin·(meth)acrylic acid obtained by incorporating (meth)acrylic acid in an epoxy resin; an urethaneacrylate such as ethylene glycol·adipic acid·tolylenediisocyanate·2-hydroxyethylacrylate, polyethylene glycol·tolylenediisocyanate·2-hydroxyethylacrylate, hydroxyethylphthalyl methacrylate·xylenediisocyanate, 1,2-polybutadieneglycol-tolylenediisocyanate-2-hydroxyethylacrylate or trimethylolpropane·propylene glycol·tolylenediisocyanate·2-hydroxyethylacrylate, obtained by incorporating (meth)acrylic acid in an urethane resin; a silicone acrylate such as polysiloxane acrylate, or polysiloxane·diisocyanate·2-hydroxyethylacrylate; an alkyd modified acrylate obtained by incorporating a methacroyl group in an oil modified alkyd resin; and a spiran resin acrylate.

As the ethylenically unsaturated compound, there are a monomer such as a phosphazene monomer/triethylene glycol/EO modified isocyanuric acid diacrylate, an EO modified isocyanuric acid triacrylate, dimethyloltricyclodecane diacrylate, trimethylolpropane acrylate benzoate, an alkylene glycol acrylate, or a urethane modified acrylate, or an addition polymerizable oligomer or prepolymer having a structural unit derived from the above monomer.

As the ethylenically unsaturated compound, there is a phosphate compound having at least one (meth)acryloyl group. The phosphate compound is a compound having a (meth)acryloyl group in which at least one hydroxyl group of phosphoric acid is esterified, and the phosphate compound is not limited as long as it has a (meth)acryloyl group.

Besides the above compounds, compounds disclosed in Japanese Patent O.P.I. Publication Nos. 58-212994, 61-6649, 62-46688, 62-48589, 62-173295, 62-187092, 63-67189, and 1-244891, compounds described on pages 286 to 294 of "11290 Chemical Compounds" edited by Kagakukogyo Nipposha, and compounds described on pages 11 to 65 of "UV·EB Koka Handbook (Materials)" edited by Kobunshi Kankokai can be suitably used. Of these compounds, compounds having two or more acryl or methacryl groups in the molecule are preferable, and those having a molecular weight of not more than 10,000, and preferably not more than 5,000 are more preferable.

In the invention, the content of the ethylenically unsaturated compound described above in the photopolymerizable light sensitive layer is preferably from 1.0 to 80.0% by weight, and more preferably from 3.0 to 70.0% by weight.

It is preferred that the photopolymerizable light sensitive layer in the invention contain two or more kinds of the ethylenically unsaturated compound described above.

### (2) Photopolymerization initiator

A photopolymerization initiator used in the invention is a compound capable of initiating polymerization of a photopolymerizable ethylenically unsaturated monomer upon imagewise light exposure. The photopolymerization initiator is preferably a titanocene compound, a monoalkyltriarylborate, an iron-arene complex or a trihaloalkyl-containing compound. These initiators are preferably used as an admixture of two or more kinds thereof.

As the titanocene compounds, there are compounds disclosed in Japanese Patent O.P.I. Publication Nos. 63-41483 and 2-291. Preferred examples thereof include bis(cyclopentadienyl)-Ti-dichloride, bis(cyclopentadienyl)-Ti-bisphenyl, bis(cyclopentadienyl)-Ti-bis-2,3,4,5,6-pentafluorophenyl, bis(cyclopentadienyl)-Ti-bis-2,3,5,6-tetrafluorophenyl, bis(cyclopentadienyl)-Ti-bis-2,4,6-trifluorophenyl, bis(cyclopentadienyl)-Ti-bis-2,6-difluorophenyl, bis(cyclopentadienyl)-Ti-bis-2,4-difluorophenyl, bis(methylcyclopentadienyl)-Ti-bis-2,3,4,5,6-pentafluorophenyl, bis(methylcyclopentadienyl)-Ti-bis-2,3,5,6-tetrafluorophenyl, bis(methylcyclopentadienyl)-Ti-bis-2,4-difluorophenyl (IRUGACURE 727L, produced by Ciba Specialty Co., Ltd.), bis(cyclopentadienyl)-bis(2,6-difluoro-3-(pyry-1-yl)phenyl) titanium (IRUGACURE 784, produced by Ciba Specialty Co., Ltd.), bis(cyclopentadienyl)-bis(2,4,6-trifluora-3-(pyry-1-yl)phenyl) titanium, and bis (cyclopentadienyl)-bis (2,4,6-trifluoro-3-(2,5-dimethylpyry-1-yl) phenyl) titanium.

As the monoalkyltriaryl borate compounds, there are those described in Japanese Patent O.P.I. Publication Nos. 62-150242 and 62-143044. Preferred examples of the monoalkyltriaryl borate compounds include tetra-n-butyl ammonium n-butyl-trinaphthalene-1-yl-borate, tetra-n-butyl ammonium n-butyl-triphenyl-borate, tetra-n-butyl ammonium n-butyl-tri-(4-tert-butylphenyl)-borate, tetra-n-butyl ammonium n-hexyl-tri-(3-chloro-4-methylphenyl)-borate, and tetra-n-butyl ammonium n-hexyl-tri-(3-fluorophenyl)-borate.

In the invention, it is especially preferred that the photopolymerizable light sensitive layer contains the iron arene complex as a photopolymerization initiator. The iron arene complex used in the invention is preferably a compound represented by formula (a) below.

Formula (a) [A-Fe-B] ⁺X⁻

wherein A represents a cyclopentadienyl group or an alkylsubstituted cyclopentadienyl group; B represents an aromatic ring group; and X is an anion.

Examples of the aromatic ring include benzene, toluene, xylene, cumene, naphthalene, 1-methylnaphtalene, 2-methylnaphtalene, biphenyl, and fluorene. Examples of X include PF₆⁻, BF₄⁻, SbF₆⁻, AlF₄⁻, and CF₃SO₃⁻.

The iron arene complex content of the photopolymerizable light sensitive layer is preferably from 0.1 to 20% by weight, and more preferably from 0.1 to 10% by weight, based on the content of the polymerizable ethylenically unsaturated monomer used.

### (Trihaloalkyl-containing compound)

The photopolymerizable light sensitive layer in the invention preferably contains a trihaloalkyl-containing compound. The trihaloalkyl-containing compound is a compound having a trihaloalkyl group in the molecule, and is preferably used particularly when an addition polymerizable ethylenically unsaturated monomer containing a light oxidizable group is used in the light sensitive layer.

The trihaloalkyl-containing compound is preferably a compound containing chlorine or bromine as halogen.

The trihaloalkyl group is preferably a trihalomethyl group, and is bonded directly or through a conjugated chain to an aromatic hydrocarbon or heterocyclic ring. A compound having a triazine ring with two trihalomethyl groups is preferred, and compounds disclosed in EP-A-137,452, and DE-A-2,118,259 and 2,243,621 is especially preferred. These compounds have an absorption at near ultraviolet regions, for example, at wavelength regions from 350 to 400 nm.

An initiator having little or no absorption at the spectral regions of the emitted light, for example, trihalomethyltriazine of mesomerism structure having a substituent or aliphatic group with a short conjugated system is suitably used. A compound having an absorption at far ultraviolet regions, for example, phenyl trihalomethyl sulfone (typically, phenyl tribromomethyl sulfone) or phenyl trihalomethyl ketone, is also suitably used.

Another photopolymerization initiator can be used in combination in the photopolymerizable light sensitive layer in the invention. Examples thereof include carbonyl compounds, organic sulfur compounds, peroxides, redox compounds, azo or diazo compounds, halides and photo-reducing dyes disclosed in J. Kosar, "Light Sensitive Systems", Paragraph 5, and those disclosed in British Patent No. 1,459,563.

Typical examples of the photopolymerization initiator used in combination include the following compounds:

A benzoin derivative such as benzoin methyl ether, benzoin i-propyl ether, or α,α-dimethoxy-α-phenylacetophenone; a benzophenone derivative such as benzophenone, 2,4-dichlorobenzophenone, o-benzoyl methyl benzoate, or 4,4'-bis (dimethylamino) benzophenone; a thioxanthone derivative such as 2-chlorothioxanthone, 2-i-propylthioxanthone; an anthraquinone derivative such as 2-chloroanthraquinone or 2-methylanthraquinone; an acridone derivative such as N-methylacridone or N-butylacridone; α,α-diethoxyacetophenone; benzil; fluorenone; xanthone; an uranyl compound; a triazine derivative disclosed in Japanese Patent Publication Nos. 59-1281 and 61-9621 and Japanese Patent O.P.I. Publication No. 60-60104; an organic peroxide compound disclosed in Japanese Patent O.P.I. Publication Nos. 59-1504 and 61-243807; a diazonium compound in Japanese Patent Publication Nos. 43-23684, 44-6413, 47-1604 and US Patent No. 3,567,453; an organic azide compound disclosed in US Patent Nos. 2,848,328, 2,852,379 and 2,940,853; orthoquinondiazide compounds disclosed in Japanese Patent Publication Nos. 36-22062b, 37-13109, 38-18015 and 45-9610; various onium compounds disclosed in Japanese Patent Publication No. 55-39162, Japanese Patent O.P.I. Publication No. 59-14023 and "Macromolecules", Volume 10, p. 1307 (1977); azo compounds disclosed in Japanese Patent Publication No. 59-142205; metal arene complexes disclosed in Japanese Patent O.P.I. Publication No. 1-54440, European Patent Nos. 109,851 and 126,712, and "Journal of Imaging Science", Volume 30, p. 174 (1986); (oxo) sulfonium organoboron complexes disclosed in Japanese Patent O.P.I. Publication Nos. 5-213861 and 5-255347; titanocenes disclosed in Japanese Patent O.P.I. Publication Nos. 59-152396 and 61-151197; transition metal complexes containing a transition metal such as ruthenium disclosed in "Coordination Chemistry Review", Volume 84, p. 85-277 (1988) and Japanese Patent O.P.I. Publication No. 2-182701; 2,4,5-triarylimidazol dimmer disclosed in Japanese Patent O.P.I. Publication No. 3-209477; carbon tetrabromide; organic halide compounds disclosed in Japanese Patent O.P.I. Publication No. 59-107344.

### (3) Polymer binder

As the polymer binder can be used a polyacrylate resin, a polyvinylbutyral resin, a polyurethane resin, a polyamide resin, a polyester resin, an epoxy resin, a phenol resin, a polycarbonate resin, a polyvinyl butyral resin, a polyvinyl formal resin, a shellac resin, or another natural resin. These resins can be used as an admixture of two or more thereof.

The polymer binder used in the invention is preferably a vinyl copolymer obtained by copolymerization of an acryl monomer, and more preferably a copolymer containing (a) a carboxyl group-containing monomer unit and (b) an alkyl methacrylate or alkyl acrylate unit as the copolymerization component.

Examples of the carboxyl group-containing monomer include an α,β-unsaturated carboxylic acid, for example, acrylic acid, methacrylic acid, maleic acid, maleic anhydride, itaconic acid, itaconic anhydride or a carboxylic acid such as a half ester of phthalic acid with 2-hydroxymethacrylic acid.

Examples of the alkyl methacrylate or alkyl acrylate include an unsubstituted alkyl ester such as methylmethacrylate, ethylmethacrylate, propylmethacrylate, butylmethacrylate, amylmethacrylate, hexylmethacrylate, heptylmethacrylate, octylmethacrylate, nonylmethacrylate, decylmethacrylate, undecylmethacrylate, dodecylmethacrylate, methylacrylate, ethylacrylate, propylacrylate, butylacrylate, amylacrylate, hexylacrylate, heptylacrylate, octylacrylate, nonylacrylate, decylacrylate, undecylacrylate, or dodecylacrylate; a cyclic alkyl ester such as cyclohexyl methacrylate or cyclohexyl acrylate; and a substituted alkyl ester such as benzyl methacrylate, 2-chloroethyl methacrylate, N,N-dimethylaminoethyl methacrylate, glycidyl methacrylate, benzyl acrylate, 2-chloroethyl acrylate, N,N-dimethylaminoethyl acrylate or glycidyl acrylate.

The polymer binder in the invention can further contain, as another monomer unit, a monomer unit derived from the monomer described in the following items (1) through (14) :
(1) A monomer having an aromatic hydroxy group, for example, o-, (p- or m-) hydroxystyrene, or o-, (p- or m-) hydroxyphenylacrylate;
(2) A monomer having an aliphatic hydroxy group, for example, 2-hydroxyethyl acrylate, 2-hydroxyethyl methacrylate, N-methylolacrylamide, N-methylolmethacrylamide, 4-hydroxybutyl acrylate, 4-hydroxybutyl methacrylate, 5-hydroxypentyl acrylate, 5-hydroxypentyl methacrylate, 6-hydroxyhexyl acrylate, 6-hydroxyhexyl methacrylate, N-(2-hydroxyethyl)acrylamide, N-(2-hydroxyethyl)methacrylamide, or hydroxyethyl vinyl ether;
(3) A monomer having an aminosulfonyl group, for example, m- or p-aminosulfonylphenyl methacrylate, m- or p-aminosulfonylphenyl acrylate, N-(p-aminosulfonylphenyl) methacrylamide, or N-(p-aminosulfonylphenyl)acrylamide;
(4) A monomer having a sulfonamido group, for example, N-(p-toluenesulfonyl)acrylamide, or N-(p-toluenesulfonyl)-methacrylamide;
(5) An acrylamide or methacrylamide, for example, acrylamide, methacrylamide, N-ethylacrylamide, N-hexylacrylamide, N-cyclohexylacrylamide, N-phenylacrylamide, N-nitrophenylacrylamide, N-ethyl-N-phenylacrylamide, N-4-hydroxyphenylacrylamide, or N-4-hydroxyphenylmethacrylamide;
(6) A monomer having a fluorinated alkyl group, for example, trifluoromethyl acrylate, trifluoromethyl methacrylate, tetrafluoropropyl methacrylate, hexafluoropropyl methacrylate, octafluoropentyl acrylate, octafluoropentyl methacrylate, heptadecafluorodecyl methacrylate, heptadecafluorodecyl methacrylate, or N-butyl-N-(2-acryloxyethyl)heptadecafluorooctylsulfonamide;
(7) A vinyl ether, for example, ethyl vinyl ether, 2-chloroethyl vinyl ether, propyl vinyl ether, butyl vinyl ether, octyl vinyl ether, or phenyl vinyl ether;
(8) A vinyl ester, for example, vinyl acetate, vinyl chroloacetate, vinyl butyrate, or vinyl benzoate;
(9) A styrene, for example, styrene, methylstyrene, or chloromethystyrene;
(10) A vinyl ketone, for example, methyl vinyl ketone, ethyl vinyl ketone, propyl vinyl ketone, or phenyl vinyl ketone;
(11) An olefin, for example, ethylene, propylene, isobutylene, butadiene, or isoprene;
(12) N-vinylpyrrolidone, N-vinylcarbazole, or N-vinylpyridine,
(13) A monomer having a cyano group, for example, acrylonitrile, methacrylonitrile, 2-pentenenitrile, 2-methyl-3-butene nitrile, 2-cyanoethyl acrylate, or o-, m- or p-cyanostyrene;
(14) A monomer having an amino group, for example, N,N-diethylaminoethyl methacrylate, N,N-dimethylaminoethyl acrylate, N,N-dimethylaminoethyl methacrylate, polybutadiene urethane acrylate, N,N-dimethylaminopropyl acrylamide, N,N-dimethylacrylamide, acryloylmorpholine, N-isopropylacrylamide, or N,N-diethylacrylamide.

Further, another monomer may be copolymerized with the above monomer.

The vinyl copolymer above is obtained by a conventional solution polymerization. The vinyl copolymer can be also obtained by bulk polymerization or suspension polymerization. The polymerization initiator used is not specifically limited. As the polymerization initiator, there is an azobis type radical generating agent such as 2.2'-azobisisobutyronitrile (AIBN), or 2.2'-azobis(2-methybutyronitrile). The polymerization initiator is used in an amount of ordinarily from 0.05 to 10.0 parts by weight an d preferably from 0.1 to 5 parts by weight, based on 100 parts by weight of monomers used for preparing the copolymer. Solvents used for the solution polymerization include organic solvents such as ketone solvents, ester solvents or aromatic solvents. The solvents are preferably good solvents of acryl polymers such as toluene, ethyl acetate, benzene, methylcellosolve, ethylcellosolve, acetone or methyl ethyl ketone, and of these, solvents having a boiling point of from 60 to 120 °C are more preferred. The solvent polymerization is carried out in the above solvents at ordinarily from 40 to 120 °C, and preferably from 60 to 110 °C for ordinarily from 3 to 10 hours, and preferably from 5 to 8 hours. After the polymerization, the solvents are removed to obtain the copolymer. Alternatively, the polymerization solution can be used in a successive double bond incorporating reaction described later without removing the solvents.

The molecular weight of the copolymer can be adjusted depending on solvents used or polymerization temperature. Solvents or polymerization temperature for preparing a copolymer having an intended molecular weight are appropriately selected depending on kind of monomers used. The molecular weight of the copolymer can be adjusted by incorporating a specific solvent to the polymerization solvents above. Examples of the specific solvents include mercaptans (such as n-octylmercaptan, n-dodecylmercaptan, or mercaptoethanol) and carbon chlorides (such as carbon tetrachloride, butyl chloride or propylene chloride). The incorporating amount of the specific solvent can be appropriately determined depending on monomers or solvents used, or polymerization conditions.

The polymer binder is preferably a vinyl polymer having in the side chain a carboxyl group and a polymerizable double bond. As the polymer binder is also preferred an unsaturated bond-containing copolymer which is obtained by reacting a carboxyl group contained in the above vinyl copolymer molecule with for example, a compound having a (meth)acryloyl group and an epoxy group.

Examples of the compound having a (meth)acryloyl group and an epoxy group in the molecule include glycidyl acrylate, glycidyl methacrylate and an epoxy group-containing unsaturated compound disclosed in Japanese Patent O.P.I. Publication No. 11-27196. Further, an unsaturated bond-containing copolymer which is obtained by reacting a hydroxyl group contained in the above vinyl copolymer molecule with for example, a compound having a (meth)acryloyl group and an isocyanate group. Examples of the compound having a (meth)acryloyl group and an isocyanate group in the molecule include vinyl isocyanate, (meth)acryl isocyanate, 2-(meth) acroyloxyethyl isocyanate, m- or p-isopropenyl-α,α'-dimethylbenzyl isocyanate, and (meth)acryl isocyanate, or 2-(meth)acroyloxyethyl isocyanate is preferred.

The content of the vinyl polymer having in the side chain a carboxyl group and a polymerizable double bond is preferably from 50 to 100% by weight, and more preferably 100% by weight, based on the total weight of the polymer binder used.

The polymer binder content of the photopolymerizable light sensitive layer is preferably from 10 to 90% by weight, more preferably from 15 to 70% by weight, and still more preferably from 20 to 50% by weight, in view of sensitivity.

### (Support)

The support in the invention is a plate or film sheet capable of carrying the photopolymerizable light sensitive layer, and preferably has a hydrophilic surface on the light sensitive layer side.

Examples of the support include a plate of a metal such as aluminum, stainless steel, chromium, or nickel, a plastic film such as a polyester film, a polyethylene film or a polypropylene film which is deposited or laminated with the above-described metal, and a polyester film, a polyvinyl chloride film or a nylon film whose surface is subjected to hydrophilization treatment. Among the above, the aluminum plate is preferably used as a support. As the aluminum support is used a pure aluminum plate or an aluminum alloy plate.

As the aluminum alloy, there can be used various ones including an alloy of aluminum and a metal such as silicon, copper, manganese, magnesium, chromium, zinc, lead, bismuth, nickel, titanium, sodium or iron.

As the aluminum support, a surface-roughened aluminum support is used.

It is preferable that the support in the invention is subjected to degreasing treatment for removing rolling oil prior to surface roughening (graining). The degreasing treatments include degreasing treatment employing solvents such as trichlene and thinner, and an emulsion degreasing treatment employing an emulsion such as kerosene or triethanol. It is also possible to use an aqueous alkali solution such as caustic soda for the degreasing treatment. When an aqueous alkali solution such as caustic soda is used for the degreasing treatment, it is possible to remove soils and an oxidized film which can not be removed by the above-mentioned degreasing treatment alone. When an aqueous alkali solution such as caustic soda is used for the degreasing treatment, the resulting support is preferably subjected to desmut treatment in an aqueous solution of an acid such as phosphoric acid, nitric acid, sulfuric acid, chromic acid, or a mixture thereof, since smut is produced on the surface of the support. The surface roughening methods include a mechanical surface roughening method and an electrolytic surface roughening method electrolytically etching the support surface.

Though there is no restriction for the mechanical surface roughening method, a brushing roughening method and a honing roughening method are preferable.

Though there is no restriction for the electrolytic surface roughening method, a method in which the support is electrolytically surface roughened in an acidic electrolytic solution.

After the support has been electrolytically surface roughened, it is preferably dipped in an acid or an aqueous alkali solution in order to remove aluminum dust, etc. produced in the surface of the support. Examples of the acid include sulfuric acid, persulfuric acid, hydrofluoric acid, phosphoric acid, nitric acid and hydrochloric acid, and examples of the alkali include sodium hydroxide and potassium hydroxide. Among those mentioned above, the aqueous alkali solution is preferably used. The dissolution amount of aluminum in the support surface is preferably 0.5 to 5 g/m². After the support has been dipped in the aqueous alkali solution, it is preferable for the support to be dipped in an acid such as phosphoric acid, nitric acid, sulfuric acid and chromic acid, or in a mixed acid thereof, for neutralization.

The mechanical surface roughening and electrolytic surface roughening may be carried out singly, and the mechanical surface roughening followed by the electrolytic surface roughening may be carried out.

After the surface roughening, anodizing treatment may be carried out. There is no restriction in particular for the method of anodizing treatment used in the invention, and known methods can be used. The anodizing treatment forms an anodization film on the surface of the support.

The support which has been subjected to anodizing treatment is optionally subjected to sealing treatment. For the sealing treatment, it is possible to use known methods using hot water, boiling water, steam, a sodium silicate solution, an aqueous dicromate solution, a nitrite solution and an ammonium acetate solution.

After the above treatment, the support is suitably undercoated with a water soluble resin such as polyvinyl phosphonic acid, a polymer or copolymer having a sulfonic acid in the side chain, or polyacrylic acid; a water soluble metal salt such as zinc borate; a yellow dye, an amine salt; and so on. The sol-gel treatment support, which has a functional group capable of causing addition reaction by radicals as a covalent bond, is suitably used.

The photopolymerizable light sensitive layer in the invention is formed by providing a coating liquid for the photopolymerizable light sensitive layer, coating the coating liquid on the support according to a conventional method, and drying the coating layer. Examples of the coating method include an air doctor coating method, a blade coating method, a wire bar coating method, a knife coating method, a dip coating method, a reverse roll coating method, a gravure coating method, a cast coating method, a curtain coating method, and an extrusion coating method.

The drying temperature of the coating layer above is preferably from 60 to 160° C, more preferably from 80 to 140° C, and still more preferably from 90 to 120° C, in minimizing fogs at non-image portions.

### EXAMPLES

Next, the present invention will be explained below employing examples, but the present invention is not limited thereto. In the examples, "parts" represents "parts by weight", unless otherwise specified.

### Example 1

### (Planographic printing plate material samples 101 through 106)

Methyl methacrylate of 58.0 parts, 35.0 parts of methacrylic acid, 6.0 parts of ethyl methacrylate, 100 parts of ethanol, and 1.23 parts of α,α-azobisisobutylonitrile were placed in a three neck flask under nitrogen atmosphere, and reacted under nitrogen atmosphere for 6 hours at 80°C in an oil bath.

After that, the reaction mixture was added with one part of triethylbenzylammonium chloride and 28 parts of glycidyl methacrylate, and refluxed at 25 °C for 3 hours. Thus, polymer binder A was obtained. The polymer binder A had a weight average molecular weight of 70,000, measured according to GPC, and had an acid value of 95.

### (Preparation of support)

A 0.30 mm thick aluminum plate (material 1050, refining H16) was degreased at 65° C for one minute in a 5% sodium hydroxide solution, washed with water, immersed at 25° C for one minute in a 10% sulfuric acid solution to neutralize, and then washed with water. The resulting aluminum plate was electrolytically etched using an alternating current at 25° C for 20 seconds at a current density of 50 A/dm² and at a frequency of 50 Hz in an aqueous 11 g/liter hydrochloric acid solution, washed with water, desmutted at 50° C for 10 seconds in a 1% sodium hydroxide solution, washed with water, neutralized at 50° C for 30 seconds in a 30 % sulfuric acid solution, and washed with water. The desmutted aluminum plate was anodized at 25° C for 40 seconds at a current density of 5 A/dm² and at a voltage of 15 V in a 20% sulfuric acid solution, and washed with water.

The resulting anodized aluminum plate was immersed in a 0.44% polyvinyl phosphonic acid aqueous solution at 75° C for 30 seconds, washed with pure water, and dried blowing cool air. Thus, support for a photopolymerizable light sensitive planographic printing plate material sample was obtained. The center line average surface roughness (Ra) of the support was 0.65 µm.

### (Preparation of planographic printing plate material sample)

The following photopolymerizable light sensitive layer coating liquid was coated on the resulting support using a wire bar, and dried at 110° C for 1.5 minutes to give a photopolymerizable light sensitive layer with a dry thickness of 1.9 g/m². After that, the following oxygen protective layer coating liquid was coated on the photopolymerizable light sensitive layer using an applicator, and dried at 75° C for 1.5 minutes to give an oxygen shielding layer with a dry thickness of 1.5 g/m². Thus, planographic printing plate material sample with protective layer provided on light sensitive layer was prepared.

### <<Photopolymerizable light sensitive layer coating liquid>>

| | |
|---|---|
| Polymer binder A 1 | 45.0 parts |
| Sensitizing dye A | 4.0 part |
| Iron-arene compound IRGACURE 261 (produced by Ciba Specialty Chemicals Co.) | 3.2 parts |
| Triazine Compound TAZ-107 (produced by Midori Kagaku Co., Ltd.) | 2.5 part |
| Addition polymerizable ethylenically unsaturated monomer (Compound A) | 30.0 parts |
| Polyethylene glycol #200 dimethacrylate (NK ESTER-4G, produced by Shinnakamura Kagaku Kogyol Co., Ltd.) | 15.0 parts |
| Phthalocyanine pigment (MHI 454 produced by Mikuni Sikisosha 30% MEK dispersion) | 3.0 parts |
| ANCAMIN K-54 (produced by AIR PRODUCTS Co., Ltd.) | 1.45 parts |
| Hindered amine stabilizer (LS 770 produced by Mitusi Life-Tech Co., Ltd.) | 0.5 parts |
| Fluorine-contained surfactant (F-178K produced by Dainippon ink Kagaku Kogyo Co., Ltd.) | 0.5 parts |
| Cyclohexanone (bp. 155°C) | 820 parts |

### Sensitizing dye A

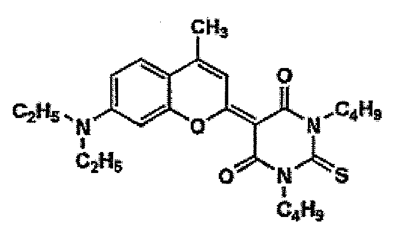

### Compound A

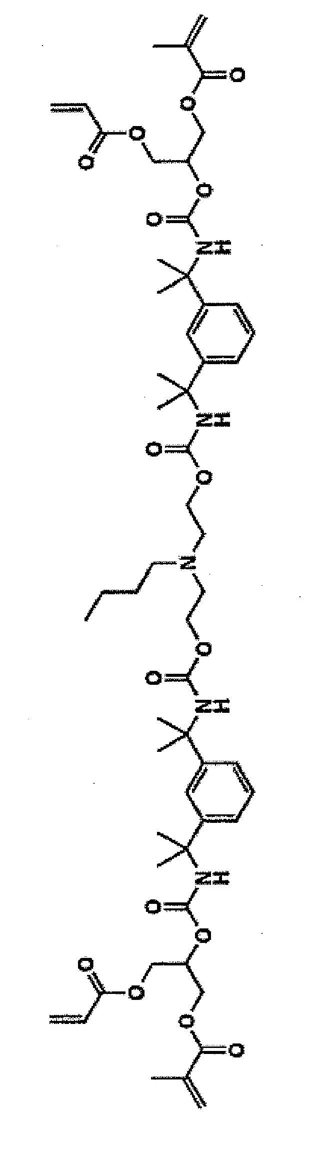

### <<Protective layer coating liquid>

Polyvinyl alcohol (PVA) or its derivative The kind or amount is as shown in Table 1.

| | |
|---|---|
| Surfactant (Surfinol 465, produced by Nisshin Kagaku Co., Ltd.) | 0.5 parts |
| Water | 900 parts |

### Polyvinyl alcohol derivative PVAH-1:

In a 5 liter vessel with a stirrer, a reflux condenser, a nitrogen incorporating tube and a thermometer were placed 2040 g of vinyl acetate, 905 g of methanol, 110.7 g of a 50% N-vinyl-2-caprolactam methanol solution, and 4.3 g of a 10% itaconic acid methanol solution. The resulting solution was bubbled with a nitrogen gas for 30 minutes, and degassed. Subsequently, the solution was heated to 60 °C, and added with 1.5 g of 2,2'-azobisisobutyronitrile to initiate polymerization. Polymerization was carried out for 3 hours while gradually adding the 50% N-vinyl-2-caprolactam methanol solution, 10% itaconic acid methanol solution and vinyl acetate so that the mole ratio thereof was the same as initially placed in the vessel. After that, the resulting solution was cooled to terminate the polymerization. The solid content of the solution was 34%. Then, residual vinyl acetate was removed from the solution under reduced pressure optionally adding methanol. Thus, a vinyl acetate copolymer methanol solution (having a copolymer concentration of 33%) was obtained. The vinyl acetate copolymer methanol solution was diluted with methanol to obtain a 25% vinyl acetate copolymer methanol solution. To the resulting methanol solution was added a 10% NAOH methanol solution in an alkali mole ratio (mole number of NAOH/mole number of vinyl acetate unit in the copolymer) of 0.01. Thus, vinyl acetate copolymer was ssponified, and purified employing methanol. Thus, polyvinyl alcohol derivative PVAH-1 was obtained.

### (Image formation)

The photopolymerizable light sensitive planographic printing plate material sample obtained above was imagewise exposed at a resolving degree of 2400 dpi, employing a modified plate setter of a plate setter Tiger Cat (produced by ECRM Co., Ltd.) equipped with a laser with an output power of 30 mW emitting light with a wavelength of 408 nm. Herein, dpi represents the dot numbers per 2.54 cm.

Subsequently, the exposed sample was subjected to development treatment employing a CTP automatic developing machine (PHW 32-V produced by Technigraph Co., Ltd.) to obtain a planographic printing plate. Herein, the developing machine comprised a preheating section for preheating the exposed sample, a pre-washing section for removing the protective layer before development, a development section charged with developer having the following developer composition, a washing section for removing the developer remaining on the developed sample after development, and a gumming section charged with a gumming solution (a solution obtained by diluting GW-3, produced by Mitsubishi Chemical Co., Ltd., with water by a factor of 2) for protecting the surface of the developed sample. Thus, planographic printing plate sample was obtained. Herein, preheating was carried out at 110 °C for 15 seconds. The preheating temperature was measured employing a thermo label (produced by Nichiyu Giken Co., Ltd.) adhered on the rear surface of the support opposite the light sensitive layer.

### <Composition of developer>

| | |
|---|---|
| Potassium silicate A (an aqueous potassium silicate solution containing 25.5-27.5% by weight of SiO₂ and 12.5-14.5% by weight of K₂O) | 8.0 parts |
| NEWCOL B-13SN (produced by Nippon Nyukazai Co., Ltd.) | 3.0 parts |
| Disodium ethylenediaminetetraacetate dihydrate | 0.1 parts |
| Potassium hydroxide | Amount giving pH 12.1 |

### (Evaluation of light sensitive planographic printing plate material sample)

The resulting light sensitive planographic printing plate material sample was evaluated as follows:

### Sensitivity

### <<Sensitivity>>

The light sensitive planographic printing plate material sample obtained above was exposed at various exposure energy levels of laser used to obtain solid images, and reflection densities of the resulting solid images were measured. An exposure energy giving a solid mage with a reflection density 10% lower than a maximum reflection density of the reflection densities of the solid images was defined as sensitivity.

### <<Storage stability>>

The light sensitive planographic printing plate material sample was stored at 55 °C and at 20% RH for 3 days in a thermostatic chamber (DT storage). Sensitivity of the resulting sample was measured in the same manner as above, and was compared with that before storage. Sensitivity variation between the samples before and after storage was evaluated as a measure of storage stability.

With respect to the light sensitive planographic printing plate material sample after the storage, the following anti-stain property was determined and evaluated as a measure of storage stability.

### <<Anti-stain property>>

The light sensitive planographic printing plate material sample after the storage was developed in the same manner as above, and ink-processed employing a developing ink PI-2 and PS sponge, each produced by Fuji Shasin Film Co., Ltd., sufficiently washed with water, followed by drying. The resulting planographic printing plate was observed with a loupe, and the anti-stain property was evaluated according to the following criteria:
A: No stain was observed.
B: Slight stain was observed.
C: Apparent stain was observed.

### <<Pre-heating latitude>>

The exposed light sensitive planographic printing plate material sample was subjected to development treatment in the same manner as above, except that the preheating temperature was varied, and was ink-processed in the same manner as above to obtain a printing plate sample. Subsequently, printing was carried out employing the resulting printing plate sample as described below, and the maximum pre-heating temperature at which neither stain at non-image portions nor filling-up at shadow image portions was produce was determined.

A printing plate sample having an image with a dot area of from 3 to 95% at a screen line number of 175, which was obtained by exposing the light sensitive planographic printing plate sample and developing in the same manner as above, was mounted on a press (DAIYA1F-1 produced by Mitsubishi Jukogyo Co., Ltd.), and printing was carried out wherein a coat paper, printing ink (Toyo King Hyeco Magenta M produced by Toyo Ink Manufacturing Co., Ltd.), and dampening water (SG-51, H solution produced by Tokyo Ink Co., Ltd., Concentration: 1.5%) were used. The maximum pre-heating temperature at which neither stain at non-image portions nor filling-up at shadow image portions was produce was determined.

In this evaluation, the pre-heating section of the automatic developing machine was switched off. The planographic printing plate material sample was pre-heated in a separate heater in a safe-light room to elevate to an intended temperature in 30 seconds.

### <<Solubility to 50 °C water>>

In the invention, solubility to 50 °C water of sample is determined as follows: Fifty grams of sample (obtained by passing through a 14 mesh filter) is added to 1 liter of 50 °C water, stirred with a stirrer with a 5 cm stirrer piece at 250 rpm for 30 minutes, filtered with a 300 mesh metal filter to obtain a residue on the filter. The solubility is a value obtained by subtracting the amount of the residue from the amount of the sample to have been added.

The results are shown in Table 1.

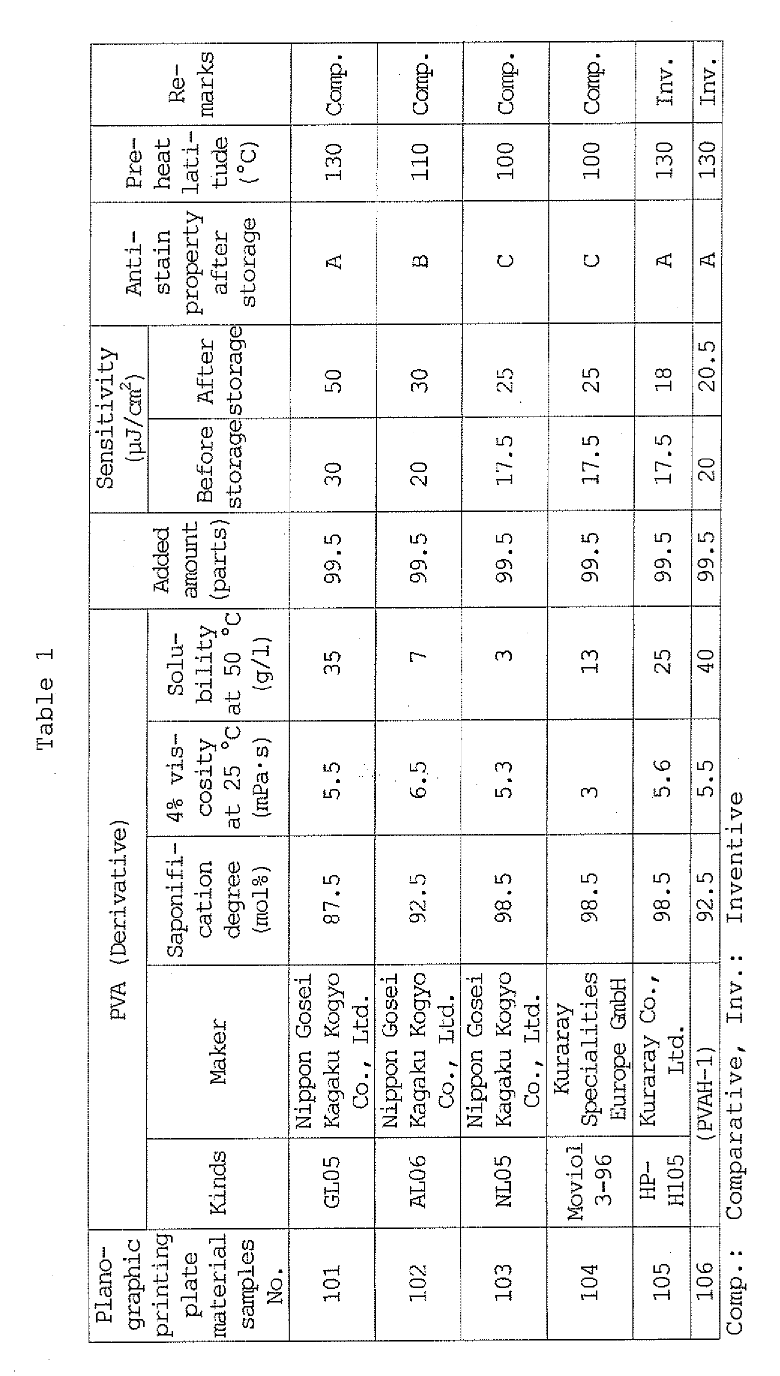

As is apparent from Table 1, the planographic printing plate material of the invention provides high sensitivity, excellent storage stability, and high pre-heating latitude.

### Example 2

### (Planographic printing plate material samples 201 through 207)

A planographic printing plate material sample was prepared in the same manner as in Example 1 of the present Specification, except that the following protective layer coating liquid was used. The resulting sample was evaluated in the same manner as in Example 1 above, provided that evaluation as described below was added.

### <<Protective layer coating liquid>

### Polyvinyl alcohol derivative

The kind or amount is as shown in Table 2.

### Polyvinyl alcohol (PVA)

The kind or amount is as shown in Table 2.

| | |
|---|---|
| Surfactant (Surfinol 465, produced by Nisshin Kagaku Co., Ltd.) | 0.5 parts |
| Water | 900 parts |

### <<Evaluation of coatability of protective layer>>

The number per m² of image defects of the planographic printing plate material sample after imagewise exposure was counted and defined as a measure of coatability.

The planographic printing plate material sample was exposed employing the modified plate setter above, and the number per m² of image defects of the exposed planographic printing plate material sample was counted, in which the image defects were defects with a diameter of not less than 300 µm.

The results are shown in Table 2.

**Table 2**

| Planograhic printing plate material samples No. | Added amount (parts) of PVA derivative HP-H105 | Added amount (parts) of PVA NL05 | Image defects | Sensitivity (µJ/cm²) | | Anti-stain property after storage | Pre-heat latitude (°C) | Remarks |
|---|---|---|---|---|---|---|---|---|
| | | | Number per m² | Before storage | After storage | | | |
| 201 | 99.5 | 0 | 10 | 17.5 | 18 | A | 130 | Inv. |
| 202 | 61 | 38.5 | 13 | 17.5 | 18 | A | 130 | Inv. |
| 203 | 51 | 48.5 | 12 | 17.5 | 18 | A | 130 | Inv. |
| 204 | 46 | 53.5 | 10 | 17.5 | 18.5 | A | 130 | Inv. |
| 205 | 41 | 58.5 | 14 | 17.5 | 18.5 | A | 130 | Inv. |
| 206 | 38 | 61.5 | 23 | 17.5 | 20 | A | 125 | Inv. |
| 207 | 0 | 99.5 | 130 | 17.5 | 25 | C | 100 | Comp. |

| | | | | | | | | |
|---|---|---|---|---|---|---|---|---|
| Comp.: Comparative, Inv.: Inventive | | | | | | | | |

As is apparent from Table 2, the planographic printing plate material of the invention provides good protective layer coatability, high sensitivity, excellent storage stability, and high pre-heating latitude. The planographic printing plate material sample of the invention comprising 40% or more of polyvinyl alcohol derivative is especially preferred.

### Example 3

### (Planographic printing plate material samples 301 through 307)

A planographic printing plate material sample was prepared in the same manner as in Example 1 of the present Specification, except that the following protective layer coating liquid was used. The resulting sample was evaluated in the same manner as in Example 2 above.

### <<Protective layer coating liquid>

### Polyvinyl alcohol derivative

The kind or amount is as shown in Table 3.

### Polyvinyl alcohol (PVA)

The kind or amount is as shown in Table 3.

| | |
|---|---|
| Surfactant (Surfinol 465, produced by Nisshin Kagaku Co., Ltd.) | 0.5 parts |
| Water | 900 parts |

The results are shown in Table 3.

**Table 3**

| Planographic printing plate material samples No. | Added amount (parts) of PVA derivative HP-H105 | Added amount (parts) of PVA GL05 | Image defects Number per m² | Sensitivity (µJ/cm²)) | | Anti-stain property after storage | Pre-heat latitude (°C) | Remarks |
|---|---|---|---|---|---|---|---|---|
| | | | | Before storage | After storage | | | |
| 301 | 99.5 | 0 | 10 | 17.5 | 18 | A | 130 | Inv. |
| 302 | 95.5 | 4 | 10 | 17.5 | 18 | A | 130 | Inv. |
| 303 | 93.5 | 6 | 2.5 | 17.5 | 18 | A | 130 | Inv. |
| 304 | 74.5 | 25 | 0.9 | 18 | 18.5 | A | 130 | Inv. |
| 305 | 50.5 | 49 | 0.6 | 18 | 18.5 | A | 130 | Inv. |
| 306 | 46.5 | 53 | 1 | 20 | 21 | A | 130 | Inv. |
| 307 | 0 | 99.5 | 1 | 30 | 50 | A | 130 | Comp. |

| | | | | | | | | |
|---|---|---|---|---|---|---|---|---|
| Comp.: Comparative, Inv.: Inventive | | | | | | | | |

As is apparent from Table 3, the planographic printing plate material of the invention provides high sensitivity, excellent storage stability, and high pre-heating latitude, and protective layer coatability with practical level. The planographic printing plate material sample of the invention comprising from 5 to 50% of compound B is especially preferred in providing both high sensitivity and minimized image defects.

### Example 4

### (Planographic printing plate material samples 401 through 412)

A planographic printing plate material sample was prepared in the same manner as in Example 1 of the present Specification, except that the following protective layer coating liquid was used. The resulting sample was evaluated in the same manner as in Example 1 above, provided that evaluation as described below was added.

### <<Protective layer coating liquid>

### Polyvinyl alcohol derivative

The kind or amount is as shown in Table 4.

### Polyvinyl alcohol (PVA)

The kind or amount is as shown in Table 4.

### Vinyl pyrrolidone copolymer (VA64W, produced by BASF Co., Ltd.)

The kind or amount is as shown in Table 4.

| | |
|---|---|
| Surfactant (Surfinol 465, produced by Nisshin Kagaku Co., Ltd.) | 0.5 parts |
| Water | 900 parts |

### <<Evaluation of adhesion>>

Scratch test was carried out to evaluate adhesion of protective layer.

The resulting planographic printing plate material sample was allowed to stand at 25 °C and 50% RH for 2 hours under a fluorescent lamp.

The resulting sample obtained above was scratched at a speed 1000 mm/min. with a sapphire needle having a tip diameter of 0.1 mm through a scratch tester Heidon-18 produced by Heidon Co., Ltd., load, the weight changed from 0 to 100 g, being applied to the sapphire needle. The minimum load at which the protective layer was peeled from the light sensitive layer was measured five times, and the average was regarded as a measure of protective layer adhesion. The results are shown in Table 4.

The results are shown in Table 4.

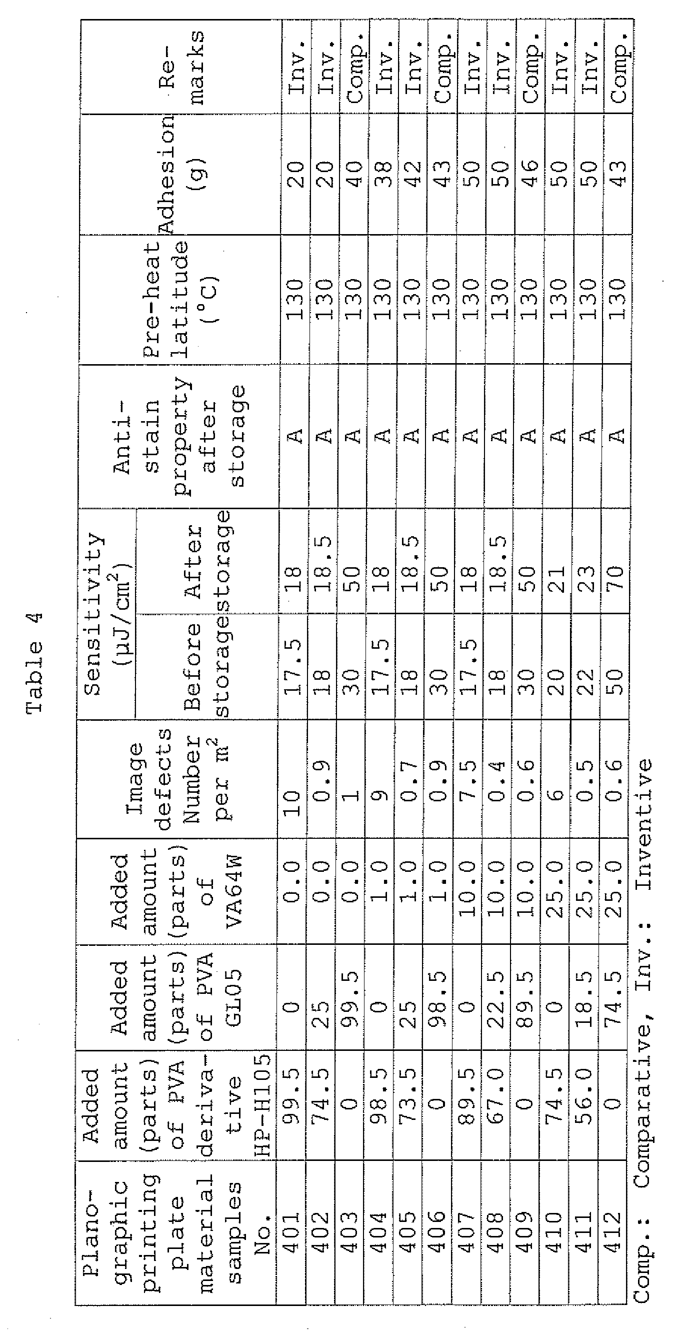

As is apparent from Table 4, the planographic printing plate material of the invention provides high sensitivity, excellent storage stability, and high pre-heating latitude, good protective layer adhesion, and protective layer coatability with practical level.

## Claims

1. A planographic printing plate material comprising a support and provided thereon, a photopolymerizable light sensitive layer and a protective layer in the order, wherein the protective layer contains a polyvinyl alcohol derivative A having a saponification degree of 90 to 100 mol% and a solubility of 0.1 to 10 g per liter of 50 °C water, and wherein a viscosity at 20 °C of an aqueous solution containing 4% by weight of the polyvinyl alcohol derivative, measured according to JIS K6726, is from 4.5 to 200 mPa·s.

2. The planographic printing plate material of claim 1, wherein the content of the polyvinyl alcohol derivative A in the protective layer is from 40 to 100% by weight.

3. The planographic printing plate material of claim 2, wherein the content of the polyvinyl alcohol derivative A in the protective layer is from 40 to 94% by weight.

4. The planographic printing plate material of claim 1 or 3, wherein the protective layer further contains a polyvinyl alcohol B having a saponification degree of 85 to 90 mol%.

5. The planographic printing plate material of claim 4, wherein the content of the polyvinyl alcohol B in the protective layer is from 5 to 50% by weight.

6. The planographic printing plate material of claim 4, wherein the content of the polyvinyl alcohol B in the protective layer is from 5 to 30% by weight based on the polyvinyl alcohol derivative.

7. The planographic printing plate material of claim 1, wherein the protective layer further contains 1 to 30% by weight of a vinyl pyrrolidone polymer C (a vinyl pyrrolidone homopolymer or a vinyl pyrrolidone copolymer) having a weight average molecular weight of from 10,000 to 500,000 and having a vinyl pyrrolidone unit of not less than 40 mol%.

8. The planographic printing plate material of claim 1, wherein the protective layer is formed by coating a protective layer coating liquid on the photopolymerizable light sensitive layer, and drying, the protective layer coating liquid containing a polyvinyl alcohol derivative A having (a) a saponification degree of 90 to 100%, (b) a viscosity of from 4.5 to 200 mPa·s, and (c) a solubility of 0.1 to 10 g per liter of to 50 °C water, the viscosity being a viscosity at 20 °C of an aqueous solution containing 4% of the polyvinyl alcohol derivative, measured according to JIS K6726.
